# EUROPÄISCHE PATENTSCHRIFT

(11) **EP 3 332 420 B1**
(45) Veröffentlichungstag und Bekanntmachung des Hinweises auf die Patenterteilung: **11.11.2020**
(21) Anmeldenummer: 16745482.6
(22) Anmeldetag: 02.08.2016
(51) Int. Cl.: H01L 23/373, H01L 23/427, H01L 23/467, H01L 23/473

(54) **BAUTEILMODUL UND LEISTUNGSMODUL**
COMPONENT MODULE AND POWER MODULE
MODULE DE COMPOSANT ET MODULE DE PUISSANCE

(30) Priorität: 05.08.2015 DE 102015214928
(43) Veröffentlichungstag der Anmeldung: 13.06.2018
(73) Patentinhaber: Siemens Aktiengesellschaft, 80333 München (DE)
(72) Erfinder: STEGMEIER, Stefan, 81541 München (DE)
(86) Internationale Anmeldenummer: PCT/EP2016/068394
(87) Internationale Veröffentlichungsnummer: WO 2017/021394

(56) Entgegenhaltungen:
- WO-A1-2015/086184
- DE-A1- 10 055 454
- DE-A1- 10 221 138
- DE-A1- 10 244 805
- FR-A1- 2 760 593
- JP-A- 2006 352 080
- US-A1- 2005 103 480

## Beschreibung

Die Erfindung betrifft ein Bauteilmodul und ein Leistungsmodul.

In der Elektronik, insbesondere der Leistungselektronik, bedingen das Schalten und das Leiten von Strömen in Halbleiterbauelementen, insbesondere IGBTs, Dioden, MOSFETs etc., Verlustleistungen. Solche Verlustleistungen müssen von einem Kühler aufgenommen werden, so dass sich solche Halbleiterbauelemente nicht erhitzen und ein effizienter Betrieb sichergestellt ist. Es ist bekannt, Leistungsbauelemente unterseitig durch lunkerfreies Löten, Diffussionslöten oder Sintern auf ein Substrat (DCB, AMB etc.) aufzubringen, wobei das Substrat seinerseits flächig an einen Kühler angebunden ist. Häufig ist die Kühlung dabei jedoch nicht effizient. Die daraus resultierende Erhitzung solcher Leistungsbauelemente hat regelmäßig eine erhöhte Ausfallrate der Leistungsbauelemente sowie ein frühzeitiges Versagen von Isolationsmaterial infolge thermischer Degradation zur Folge. Oberseitig ist eine Kühlung von Leistungsbauelementen häufig besonders schwierig, da aufgrund der oft eingesetzten Drahtbond- oder Bändchenbond-Technologie zur elektrischen Isolation ein Material vergossen wird, welches eine thermische Energieabfuhr behindert.

WO 2015/086184 A1 (ABB TECHNOLOGY AG [CH]) 18. Juni 2015 (2015-06-18) beschreibt ein Bauteilmodul.

Es ist daher Aufgabe der Erfindung, ein Bauteilmodul sowie ein Leistungsmodul anzugeben, bei denen die Kühlung von Bauelementen verbessert ist.

Diese Aufgabe der Erfindung wird mit einem Bauteilmodul mit den in Anspruch 1 angegebenen Merkmalen sowie mit einem Leistungsmodul mit den in Anspruch 9 angegebenen Merkmalen gelöst. Bevorzugte Weiterbildungen der Erfindung ergeben sich aus den zugehörigen Unteransprüchen, der nachfolgenden Beschreibung und der Zeichnung.

Das erfindungsgemäße Bauteilmodul weist ein Bauteil mit zumindest einem elektrischen Kontakt auf. Bei dem Bauteilmodul gemäß der Erfindung ist an dem zumindest einen Kontakt zumindest ein offenporiges Kontaktstück zur elektrischen Kontaktierung angebunden. Das Bauteilmodul gemäß der Erfindung weist zudem ein Kühlsystem zur Kühlung des Bauteils mit einem Kühlfluid auf. Das Kühlsystem umfasst einen oder mehrere Kühlkanäle, die mittels Poren des offenporigen Kontaktstücks gebildet sind.

Erfindungsgemäß fungiert dabei das offenporige Kontaktstück also nicht allein zur elektrischen Kontaktierung, sondern das Kontaktstück ermöglicht auch einen thermischen Kontakt zu einem Kühlfluid. Auf diese Weise kann eine Wärmeabfuhr direkt am Bauteil erfolgen, so dass die Wärmeabfuhr besonders effizient ist. Insbesondere muss die Wärmeabfuhr nicht über mehrere Schichten erfolgen, so dass die Wärmeleitfähigkeit solcher Schichten die mögliche Wärmeabfuhr nicht begrenzt. Vielmehr erfolgt die Wärmeabfuhr mittels des Kühlfluides bei dem erfindungsgemäßen Bauteilmodul in beliebiger räumlicher Nähe zum Bauteil. Infolge der effizienten Wärmeabfuhr ist die Ausfallsicherheit des Bauteilmoduls sowie die Beständigkeit gegebenenfalls vorhandener Isolationsmaterialien deutlich erhöht.

Zweckmäßigerweise ist bei dem erfindungsgemäßen Bauteilmodul das Kontaktstück galvanisch und/oder mittels Sintern und/oder mittels Löten und/oder mittels Diffusionslöten und/oder mittels Pressen und/oder mittels Klemmen und/oder mittels Kleben an den zumindest einen Kontakt des Bauteils angebunden. Mit den genannten Verfahren ist gleichzeitig ein besonders guter elektrischer Kontakt als auch ein besonders guter thermischer Kontakt zur Wärmeabfuhr durch das Kontaktstück bei dem erfindungsgemäßen Bauteilmodul gewährleistet. Vorteilhafterweise ist bei dem erfindungsgemäßen Bauteilmodul das Bauteil ein integrierter Schaltkreis. Gerade im Falle von integrierten Schaltkreisen ist eine effiziente Wärmeabfuhr besonders betriebswichtig. Gerade in dieser Weiterbildung der Erfindung ist folglich die erfindungsgemäß mögliche effiziente Wärmeabfuhr besonders vorteilhaft. In einer zweckmäßigen Weiterbildung des erfindungsgemäßen Bauteilmoduls weist dieses zumindest zwei oder mehrere Bauteile auf, die jeweils mittels eines offenporigen Kontaktstücks an eine gemeinsame Leiterplatte angebunden sind. Vorteilhaft lässt sich in dieser Weiterbildung der Erfindung die Wärme lokal an jedem Bauteil direkt abführen, was die Ausfallsicherheit des Bauteilmoduls deutlich erhöht.

Geeigneterweise ist bei dem erfindungsgemäßen Bauteilmodul das zumindest eine offenporige Kontaktstück aus oder mit Metall, insbesondere Nickel und/oder Silber und/oder Gold und/oder Zinn und/oder Kupfer, zweckmäßig als Metallschwamm, insbesondere als Kupferschwamm, gebildet. In dieser Weiterbildung des erfindungsgemäßen Bauteilmoduls ist das offenporige Kontaktstück auf besonders einfache Weise elektrisch leitend als elektrisches Kontaktstück ausgebildet. Zugleich erlauben die genannten Materialien eine offenporige Ausbildung.

Bei dem erfindungsgemäßen Bauteilmodul ist das zumindest eine offenporige Kontaktstück mit einer gewebeartigen und/oder schaumartigen und/oder netzartigen Struktur, insbesondere als Metallnetz gebildete Struktur, gebildet. Alternativ oder zusätzlich kann das offenporige Kontaktstück mit einem Stapel von Leiterrahmen gebildet sein. In dieser Weiterbildung lässt sich die Offenporigkeit des Kontaktstücks leicht gewährleisten.

Zweckmäßig ist unter *"offenporig"* im Sinne dieser Anmeldung zu verstehen, dass Poren des Kontaktstücks an dessen Oberfläche Einlässe bilden, durch welche von außen Fluid, etwa ein Kühlfluid, in das Kontaktstück eindringen kann. Idealerweise weist das offenporige Material des Kontaktstücks zudem eine offenzellige Struktur auf, durch welche hindurch Kühlfluid effizient passieren kann, vorzugsweise derart, dass das Kühlfluid das Kontaktstück durchströmt.

Zweckmäßigerweise ist bei dem erfindungsgemäßen Bauteilmodul das erfindungsgemäß vorgesehene offenporige Kontaktstück zur Leitung von Kühlfluid, insbesondere Kühlflüssigkeit, durch seine Poren besonders geeignet.

Idealerweise umfasst bei dem erfindungsgemäßen Bauteilmodul das Kühlsystem ein Wärmerohr. Mittels eines Wärmerohres ist ein besonders effizienter Kühlkreislauf realisiert.

Das erfindungsgemäße Leistungsmodul umfasst ein erfindungsgemäßes Bauteilmodul wie zuvor beschrieben. Vorzugsweise ist bei dem erfindungsgemäßen Leistungsmodul das Bauteil ein Leistungsbauteil. Gerade bei Leistungsmodulen stellt sich das Problem einer effizienten Wärmeabfuhr verstärkt, da hier eine besonders große Energiemenge zur Umwandlung in Wärmeenergie zur Verfügung steht. Beim erfindungsgemäßen Leistungsmodul ist folglich die beim erfindungsgemäßen Bauteilmodul mögliche effiziente Wärmeabfuhr ein großer Vorzug.

Nachfolgend wird die Erfindung anhand eines in der Zeichnung dargestellten Ausführungsbeispiels näher erläutert. Es zeigen:
- Figur 1: ein erstes Ausführungsbeispiel eines erfindungsgemäßen Leistungsmoduls mit einem erfindungsgemäßen Bauteilmodul mit mittels eines offenporigen Kontaktstücks des Bauteilmoduls realisierten Kühlsystem schematisch im Längsschnitt,
- Figur 2: ein zweites Ausführungsbeispiel eines erfindungsgemäßen Leistungsmoduls mit einem erfindungsgemäßen Bauteilmodul mit einem mittels eines offenporigen Kontaktstücks des Bauteilmoduls gebildeten Wärmerohr schematisch im Längsschnitt sowie
- Figur 3: eine Einzelheit der Anbindung des offenporigen Kontaktstücks der Ausführungsbeispiele gemäß den Figuren 1 und 2 in einer Prinzipskizze im Längsschnitt.

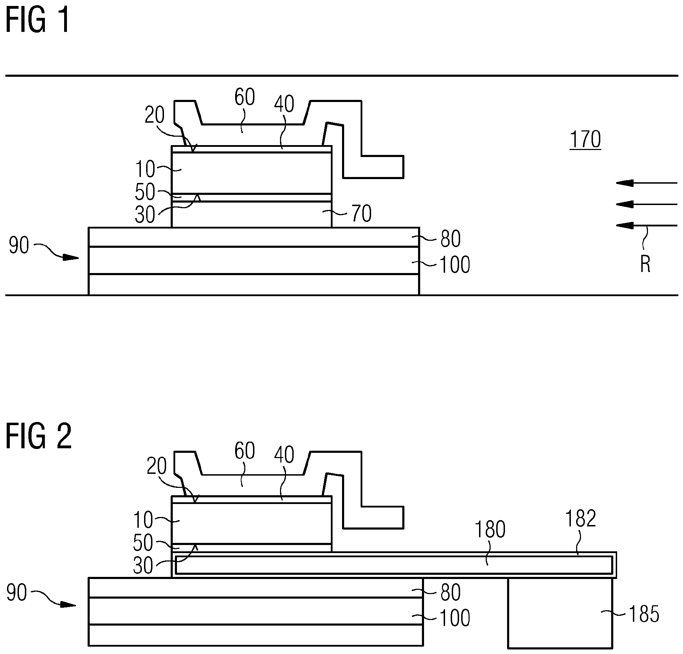

Das in Figur 1 dargestellte Leistungsbauteil 10 ist ein Bipolartransistor mit isolierter Gate-Elektrode (englisch: "Insulated-Gate Bipolar Transistor": IGBT) und weist eine erste 20 und eine zweite Flachseite 30 auf, welche voneinander abgewandt sind. Entlang der ersten 20 und zweiten Flachseite 30 erstrecken sich dünnschichtartige Flächenkontakte 40, 50 des Leistungsbauteils 10, welche als flächige Chipmetallisierungen ausgebildet sind. Im dargestellten Ausführungsbeispiel besteht der in Figur 1 oberseitig angeordnete Flächenkontakt 40 des Leistungsbauteils aus Kupfer, während der unterseitig angeordnete Flächenkontakt 50 des Leistungsbauteils aus Silber besteht. Grundsätzlich können oberseitige Flächenkontakte 40 auch aus oder mit Silber oder aus oder mit AlSiCu, sonstigen Metallen oder anderen elektrisch leitenden Materialien gebildet sein, während die unterseitigen Flächenkontakte 50 auch aus oder mit Gold und/oder anderen Metallen oder anderen elektrisch leitenden Materialien gebildet sein können.

Zur Kontaktierung dieser Flächenkontakte 40, 50 sind an den Flächenkontakten 40, 50 anliegend Kontaktstücke 60, 70 offenporigen Materials platziert, welche sich im Wesentlichen flächig entlang der Flächenkontakte 40, 50 erstrecken. Im dargestellten Ausführungsbeispiel sind die Kontaktstücke 60, 70 leitfähig ausgebildet und als Kupferschwämme realisiert. Es versteht sich, dass in weiteren, nicht eigens dargestellten Ausführungsbeispielen, welche im Übrigen den anhand der Figuren erläuterten Ausführungsbeispielen entsprechen, die offenporigen Kontaktstücke 60, 70 auch aus sonstigen offenporigen leitfähigen Materialien bestehen können, etwa aus Geweben oder Netzen oder sonstigen porösen Strukturen gebildete Aluminium- oder Titankontaktstücke oder aus oder mit sonstigen Metallen gebildete Kontaktstücke. Beispielsweise können auch mit leitfähigen Materialien bereichsweise beschichtete oder mit leitfähigen Partikeln versetzte Polymerschwämme als Kontaktstücke dienen. In weiteren Ausführungsbeispielen, welche im Übrigen den dargestellten Ausführungsbeispielen entsprechen, kann das offenporige Kontaktstück mit einem Stapel von Leiterrahmen gebildet sein.

Eines der Flächenkontakte 50 des Leistungsbauteils 10 ist einem weiteren Flächenkontakt 80 eines Keramiksubstrats 90 mit einem Keramikkern 100 aus Aluminiumnitrid (AlN) zugewandt. Grundsätzlich kann der Keramikkern 100 in weiteren, nicht eigens gezeigten Ausführungsbeispielen aus einem anderen Material, beispielsweise einem anderen keramischen Material oder einem Polymer, etwa PCB oder FR4, bestehen. Der weitere Flächenkontakt 80 des Keramiksubstrats 90 ist als oberflächliche Substratmetallisierung, im dargestellten Ausführungsbeispiel als Kupfersubstratmetallisierung, ausgebildet. Der dem Keramiksubstrat 90 zugewandte Flächenkontakt 50 des Leistungsbauteils 10 und der weitere Flächenkontakt 80 des Keramiksubstrats 90 erstrecken sich zueinander parallel und bilden dabei einen Spalt aus. Dasjenige Kontaktstück 70, das an jenem dem Keramiksubstrat 90 zugewandten Flächenkontakt 50 angeordnet ist, füllt diesen ebenen Spalt vollständig aus und liegt vollflächig an diesem Flächenkontakt 50 des Leistungsbauteils 10 sowie an dem weiteren Flächenkontakt 80 des Keramiksubstrats 90 an. Das Kontaktstück 70 ist somit zur Kontaktierung von Leistungsbauteil 10 und Keramiksubstrat 90 angeordnet.

Die offenporigen Kontaktstücke 60, 70 sind galvanisch an die jeweiligen Substrat- oder Chipmetallisierungen kontaktiert und stellen somit infolge des durchgehend leitenden metallischen Kontakts eine elektrisch leitende Verbindung zwischen den jeweiligen Flächenkontakten 40, 50, 80 her.

Die Flächenkontakte 40, 50, 80 sind voneinander und von ggf. weiteren in ihrer Umgebung befindlichen elektrischen Potentialen elektrisch isoliert, indem die Flächenkontakte 40, 50, 80 an denjenigen Oberflächenbereichen, an welchen kein Kontaktstück 60, 70 anliegt, mit einem elektrischen Isolationsmaterial, im hier beschriebenen Ausführungsbeispiel mit einem Kunststoff, ummantelt sind (in den Figuren nicht explizit dargestellt).

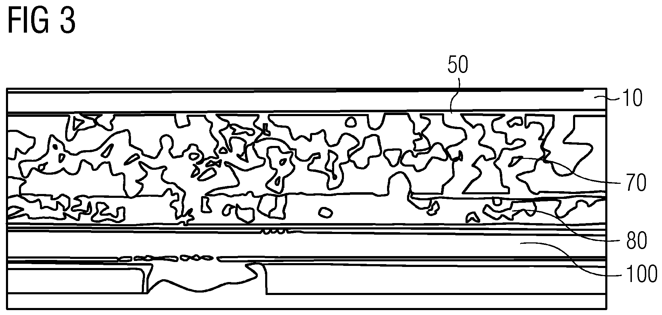

Infolge der galvanischen Anbindung der offenporigen Kontaktstücke 60, 70 ist Metall, im dargestellten Ausführungsbeispiel Kupfer, im Bereich zwischen den offenporigen Kontaktstücken 60, 70 und den Flächenkontakten 40, 50, 80 abgeschieden (Figur 3). Im dargestellten Ausführungsbeispiel sind mittels des abgeschiedenen Materials Schichten gebildet, welche sich flächig entlang der Chipmetallisierungen oder Keramiksubstratmetallisierungen sowie der Kontaktstücke 60, 70 erstrecken. Infolge dieser Abscheidung sind jeweils die offenporigen Kontaktstücke 60, 70 mit dem Leistungsbauteil verbunden. Sämtliche Kontaktstücke 60, 70 sind zugleich mit den jeweiligen Flächenkontakten 40, 50, 80 verbunden, an welchen sie jeweils anliegen. In weiteren, nicht eigens gezeigten Ausführungsbeispielen, welche im Übrigen dem dargestellten Ausführungsbeispiel entsprechen, sind die Kontaktstücke nicht galvanisch angebunden, sondern mittels Sintern oder Löten oder Diffusionslöten oder Pressen oder Klemmen oder Kleben angebunden.

Die mit Keramiksubstrat 90 und ankontaktiertem Leistungsbauteil 10 gebildeten Leistungsmodule sind in einem Fluidstrompfad 170 eines Kühlsystems des Leistungsmoduls angeordnet (Figur 1). Das Kühlsystem des Leistungsmoduls ist ausgebildet, Kühlfluid entlang einer Richtung R durch den Fluidstrompfad 170 hindurch zu leiten. Im dargestellten Ausführungsbeispiel ist der Fluidstrompfad 170 ein Luftstrompfad. In weiteren, nicht eigens dargestellten Ausführungsbeispielen, welche im Übrigen den dargestellten entsprechen, ist ein anderer Fluidstrom, beispielsweise ein Kühlgasstrom oder ein Kühlflüssigkeitsstrom, etwa ein Kühlwasserstrom, zur Kühlung vorgesehen. Das Kühlfluid kann im Fluidstrompfad 170 durch das offenporige Kontaktstück 70 hindurchtreten, sodass das offenporige Material des Kontaktstücks 70 Kühlkanäle ausbildet. Es versteht sich, dass in weiteren, nicht gesondert dargestellten Ausführungsbeispielen ein Kühlfluid nicht aktiv mittels zusätzlich vorgesehener Strömungsmittel geströmt werden muss. Vielmehr kann sich ein Fluidstrom gewissermaßen bereits selbsttätig infolge von Wärmekonvektion ausbilden.

In einem weiteren, in Figur 2 dargestellten Ausführungsbeispiel, welches im Übrigen den in Figur 1 dargestellten Ausführungsbeispiel entspricht, ist anstelle eines Luftstroms eines Kühlkreislaufs ein Wärmerohr 180 vorhanden. Das Wärmerohr 180 ist mittels des zwischen Leistungsbauteil 10 und Keramiksubstrat 90 angeordneten Kontaktstücks 70 gebildet. Das Wärmerohr 180 ist mittels des offenporigen Kontaktstücks 70 gebildet. Das offenporige Material bildet das Innere des Wärmerohres 180. Infolge der Offenporigkeit des Materials des Kontaktstücks 70 kann das Kühlfluid das Wärmerohr 180 durchströmen. Das Wärmerohr 180 weist dazu eine fluiddichte Umhausung 182 auf. Diese Umhausung 182 außenumfänglich aufgebracht, beispielsweise galvanisch oder durch Plattieren oder Löten, sodass das Kühlfluid verlustfrei durch das Wärmerohr 180 hindurch geführt wird.

Das Wärmerohr 180 bildet dabei an sich bekannter Weise einen Kühlkreislauf für eine Kühlflüssigkeit aus, wobei infolge von Verdampfung und Kondensation Wärme durch dieses aufgenommen und abgegeben wird. Dazu ist das Wärmerohr 180 an seinem dem Leistungsbauteil 10 fernen Ende an einen Kühlkörper 185 angebunden, sodass die Kühlflüssigkeit an diesem fernen Ende des Wärmerohres 180 kondensiert.

## Patentansprüche

1. Bauteilmodul mit einem Bauteil (10) mit zumindest einem elektrischen Kontakt (40, 50), bei welchem an dem zumindest einen elektrischen Kontakt (40, 50) ein offenporiges Kontaktstück (60, 70) zur elektrischen Kontaktierung angebunden ist, wobei das Bauteilmodul ein Kühlsystem zur Kühlung mit einem Kühlfluid aufweist, welches einen oder mehrere Kühlkanäle umfasst, die mittels Poren des offenporigen Kontaktstücks (60, 70) gebildet sind und bei welchem das zumindest eine offenporige Kontaktstück (60, 70) mit einer gewebeartigen und/oder schaumartigen und/oder netzartigen Struktur oder mittels gestapelter Leiterrahmen gebildet ist.

2. Bauteilmodul nach Anspruch 1, bei welchem das Kontaktstück (60, 70) galvanisch und/oder mittels Sintern und mittels Löten und/oder mittels Diffusionslöten und/oder Pressen und/oder Klemmen und/oder Kleben angebunden ist.

3. Bauteilmodul nach einem der vorhergehenden Ansprüche, welches zumindest einen integrierten Schaltkreis aufweist, wobei das Kontaktstück (60, 70) an dem zumindest einen integrierten Schaltkreis angebunden ist.

4. Bauteilmodul nach einem der vorhergehenden Ansprüche, aufweisend eine Leiterplatte (90), welches zumindest zwei oder mehrere Bauteile aufweist, die jeweils mittels eines offenporigen Kontaktstücks gemeinsam an die Leiterplatte (90) angebunden sind.

5. Bauteilmodul nach einem der vorhergehenden Ansprüche, bei welchem das zumindest eine offenporige Kontaktstück (60, 70) mittels eines offenporigen aus oder mit Metall, insbesondere Nickel und/oder Silber und/oder Gold und/oder Zinn und/oder Kupfer, insbesondere als Kupferschwamm, gebildet ist.

6. Bauteilmodul nach einem der vorhergehenden Ansprüche, bei welchem das Kühlfluid mit Wasser und/oder einer anderen Kühlflüssigkeit gebildet ist.

7. Bauteilmodul nach einem der vorhergehenden Ansprüche, bei welchem das Kühlsystem ein Wärmerohr (180) umfasst.

8. Leistungsmodul, umfassend ein Bauteilmodul nach einem der vorhergehenden Ansprüche.

9. Leistungsmodul nach Anspruch 8 , bei welchem das Bauteil ein Leistungsbauteil ist.

## Claims

1. Component module having a component (10) having at least one electrical contact (40, 50), in which an open-pore contact piece (60, 70) for making electrical contact is connected to the at least one electrical contact (40, 50), wherein the component module has a cooling system for cooling using a cooling fluid, said cooling system comprising one or more cooling ducts, which are formed by means of pores of the open-pore contact piece (60, 70), and in which the at least one open-pore contact piece (60, 70) is formed by a fabric-like and/or foam-like and/or mesh-like structure or by means of stacked leadframes.

2. Component module according to Claim 1, in which the contact piece (60, 70) is connected electrically and/or by means of sintering and by means of soldering and/or by means of diffusion soldering and/or pressing and/or clamping and/or adhesive bonding.

3. Component module according to either of the preceding claims, which has at least one integrated circuit, wherein the contact piece (60, 70) is connected to the at least one integrated circuit.

4. Component module according to one of the preceding claims, having a printed circuit board (90), which has at least two or more components, which are each jointly connected to the printed circuit board (90) by means of an open-pore contact piece.

5. Component module according to one of the preceding claims, in which the at least one open-pore contact piece (60, 70) is formed from or by metal, particularly nickel and/or silver and/or gold and/or tin and/or copper, in particular as copper sponge.

6. Component module according to one of the preceding claims, in which the cooling fluid is formed by water and/or another cooling liquid.

7. Component module according to one of the preceding claims, in which the cooling system comprises a heat pipe (180).

8. Power module, comprising a component module according to one of the preceding claims.

9. Power module according to Claim 8, in which the component is a power component.

## Revendications

1. Module de composant comportant un composant (10) pourvu d'au moins un contact électrique (40, 50), dans lequel une pièce de contact à pores ouverts (60, 70) est reliée à l'au moins un contact électrique (40, 50) pour la mise en contact électrique, le module de composant comprenant un système de refroidissement pour le refroidissement à l'aide d'un fluide réfrigérant comportant un ou plusieurs canaux de refroidissement formés par des pores de la pièce de contact à pores ouverts (60, 70) et dans lequel l'au moins une pièce de contact (60, 70) est formée à l'aide d'une structure de type textile et/ou de type mousse et/ou de type filet ou à l'aide de grilles de connexion empilées.

2. Module de composant selon la revendication 1, dans lequel la pièce de contact (60, 70) est liée galvaniquement et/ou par frittage et par brasage et/ou par brasage par diffusion et/ou par pressage et/ou par serrage et/ou par collage.

3. Module de composant selon l'une des revendications précédentes comportant au moins un circuit intégré, la pièce de contact (60, 70) étant reliée à l'au moins un circuit intégré.

4. Module de composant selon l'une des revendications précédentes comportant une carte de circuits imprimés (90) qui comporte au moins deux composants ou plus qui sont chacun reliés en commun à la carte de circuits imprimés (90) moyennant une pièce de contact à pores ouverts.

5. Module de composant selon l'une des revendications précédentes, dans lequel l'au moins une pièce de contact à pores ouverts (60, 70) est formée par du métal ou avec du métal, notamment de nickel et/ou d'argent et/ou d'or et/ou d'étain et/ou de cuivre, notamment sous forme d'éponge de cuivre.

6. Module de composant selon l'une des revendications précédentes, dans lequel le fluide réfrigérant est formé avec de l'eau et/ou un autre liquide réfrigérant.

7. Module de composant selon l'une des revendications précédentes, dans lequel le système de refroidissement comporte un caloduc (180).

8. Module de puissance, comportant un module de composant selon l'une des revendications précédentes.

9. Module de puissance selon la revendication 8, dans lequel le composant est un composant de puissance.
